# EUROPEAN PATENT APPLICATION

(11) **EP 1 494 036 A1**
(43) Date of publication of application: **05.01.2005**
(21) Application number: 03254167.4
(22) Date of filing: 30.06.2003
(51) Int. Cl.: G01R 29/10

(54) **Testing radiation efficiency of an antenna**

(71) Applicant: Telefonaktiebolaget LM Ericsson (publ), 164 83 Stockholm (SE)
(72) Inventor: Tucker, Neill, Portsmouth P08 9PL (GB)
(74) Representative: Vigars, Christopher Ian

(57) **Abstract**

There is provided an apparatus for measuring the radiation efficiency of an antenna, the apparatus comprising a chamber, a device under test holder, at least one field stirrer and a measurement device, wherein the holder, field stirrer and measurement device are mounted in line with one another within the chamber, the field stirrer being located between the holder and the measurement device. A plurality of field stirrers may be provided, the field stirrers being co-axially and rotatably mounted. The device under test holder may also be rotatable.

## Description

### FIELD OF THE INVENTION

The present invention generally relates to the testing of mobile phones and other wireless terminals, and more specifically to a chamber for use in testing of the radiating efficiency of antennas of mobile phones and other wireless terminals.

### BACKGROUND OF THE INVENTION

One of the most significant factors to be considered in the design of radio frequency (RF) wireless devices such as, for example, mobile phones, pagers, personal digital assistants and other RF equipment is that of the performance of the antenna of the device.

Typically, the most important antenna parameter is radiation efficiency, which provides a measure of the ratio of the power radiated by an antenna to the total power supplied to the antenna by the device at a given frequency. Radiation efficiency of the antenna is therefore an important measure in determining how efficiently a device is operating overall. In general terms, higher radiation efficiency is desirable. This is especially important in wireless devices designed for use in multi-path environments.

In multi-path environments, radio frequency electromagnetic waves take multiple simultaneous paths between the transmitting device and a receiving device. The multiple paths are caused as a result of reflections of the transmitted signal from objects such as buildings, walls, trees, human beings etc. An antenna should, therefore, be designed for operation in multi-path environments. Higher radiated power from an antenna of a wireless RF device generally means that the device will be better at coping with the demands of transmission in such multi-path environments. Accordingly, it is desirable for the radiation efficiency of the antenna to be high. Testing of antenna efficiency is therefore an important part of the design process.

It is desirable that any testing apparatus for RF mobile devices provides a testing environment in which true multi-path and 'Rayleigh fading' characteristics are obtainable. Rayleigh fading is fading of a signal due to the interference caused by the same signal arriving over many different paths (i.e. in a multi-path environment), resulting in out-of-phase components being incident at the receiver.

The efficiency of an antenna in terms of its radiation efficiency is determined by three main parameters: transmission losses due to mismatch at the antenna port, ohmic losses in the antenna, and ohmic losses in the external environment close to the antenna (the "near-external" environment).

The near-external environment may vary as the wireless device is used. For example, mobile telephones can be affected by the way in which the human head and hand move. Such movement affects the signal power radiated from the antenna outside of the near-external environment as RF waves can be absorbed in differing amounts by the head/hand during use. Sometimes, for example, the hand could completely obscure the antenna of the device resulting in a reduction of radiated power. Similar effects can also occur when the antenna is in a receiving mode, such that a received signal power could be attenuated as it passes through human tissue around the antenna, for example.

Typically, the radiation efficiency of an antenna is measured by performing a 'walking route' test. The test records the average level received by the wireless device while it is being used by a person walking along a predefined route. This allows the radiation efficiency of the device to be measured. The results can be compared with those of other devices tested over the same route. Testing in this manner is, however, time consuming. In addition, environments for testing are limited to those around a test site, and test measurements can easily be affected by weather conditions. It can therefore be difficult to obtain reliable, repeatable results, which may be duplicated or verified by others.

A more controlled method of measuring radiation efficiency is to use an 'anechoic' chamber. In such a chamber, the interior surfaces are covered with an absorbent material, such as carbon loaded foam, either as pyramidal cones, blankets or as horizontal and vertical wedges suitable for absorbing radio frequency radiation. Radio frequency reflection can be significantly reduced in such a chamber, thus simulating the conditions of unobstructed free space. Typically, a wireless device is arranged at one end of the chamber, with measuring equipment arranged at the other end. The device may be rotated, and the radiation pattern as a function of the rotation may be obtained at the measuring equipment. This form of test does not, however, mimic the true conditions in which a device is used, and the results may therefore not be useful when considering the overall device performance. The use of such chambers is also expensive due to the considerable time required to correctly set-up and calibrate them.

As mentioned above, multi-path effects generally need to be taken into consideration in order to obtain useful data in relation to the radiation efficiency of an antenna.

In WO 01/75460 (to Kildal Antenna Consulting AB), antenna performance is measured using a reverberation chamber which has electromagnetically reflective walls. Radio waves from a device under test reverberate within the chamber thereby simulating the multi-path and reflecting characteristics experienced by a device in the field. In addition to the electromagnetically reflective nature of the interior of the chamber, additional independent modes are obtained via the use of a long metal sheet which scans the chamber's length/width (generally referred to as a 'field stirrer').

It is common to use a holder inside such chambers as described above onto which a device under test may be mounted. The holder may be, for example, a model of a human head, and the wireless device may be a mobile phone connected thereto in a typically conventional manner. A holder of this type is referred to as a 'phantom' to indicate its similarity with the shape of a human head. Alternatively, the holder may merely be a simple stand used in order to mount a device in the chamber.

Figure 1 shows the chamber of WO 01/75460. As shown, a field stirrer (A) is operable to scan continuously across the length or width of the chamber. In this manner, continuous variation in the internal structure of the chamber is provided. The variation causes multiple changing reflections of electromagnetic waves within the chamber as the field stirrer scans. These changing reflected waves interfere with one another and increase the number of modes present within the chamber, which is desirable for testing purposes as it mimics the multi-path, multi-reflective nature of the real environment in which such a device is to be used. Field stirring in this manner can produce the effect of a near infinite number of modes and thus simulate a multi-path environment.

The apparatus and method disclosed in WO 01/75460 suffers from several problems. Field stirrers are located around the edges of the chamber, and it is therefore necessary to use a separate (radio frequency conductive, e.g. metal) screen to avoid a direct line of sight between the antenna under test and the measurement device. It is desirable to block the direct line of sight between the antenna and the measurement device so that RF waves from the antenna do not directly impinge onto the measurement device. In this way, only reflected waves are received at the measurement device, thereby simulating a multi-path environment more accurately.

This causes the apparatus as a whole to be large and cumbersome. In addition, the use of cables in the chamber causes measurement problems, as their effects on the RF fields within the chamber are difficult to determine and compensate for. Generally, the currents on such feed cables are choked off, but this method has limited success compensating for the effects of the cables. Currents on feed cables may be choked off by winding the RF cable for several turns through a toroidal ferrite, for example. Alternatively, a number of small ferrites may be threaded onto the cable to be choked, near to the antenna connection. Neither of these methods is particularly effective at frequencies above 500 MHz, however.

A further problem with the prior art method of testing is the fact that the interior of the chamber as described in WO 01/75460 is entirely electromagnetically reflective. Specifically, in order to avoid problems when measurements are obtained in the chamber using a wireless device connected to a holder, the chamber of WO 01/75460 must be large enough to avoid reflections from the interior of the chamber which would otherwise have an exaggerated effect due to multiple reflections as a result of the presence of the holder. The multiple reflections which would pass through the holder are not typical of a mobile RF environment and would thereby reduce the reliability of measurements obtained in such a fashion.

It is therefore desirable to provide a testing apparatus which enables reliable, cost and time effective, and repeatable testing of antennas which overcomes the problems mentioned above. Specifically, there exists a need for a testing apparatus in which the effect of multiple reflections is reduced, in which the effect of cables on the measurement of antenna characteristics is reduced, and in which the apparatus itself is reduced in size and complexity.

### SUMMARY OF THE PRESENT INVENTION

According to the present invention there is provided a method and apparatus for the testing of wireless devices in a true multi-path environment with Rayleigh fading characteristics in which the size of the apparatus is minimized via the novel use of co-axially mounted, rotatable field stirrers mounted in the direct line of sight between the device under test and the measurement equipment, the apparatus further including the use of radio absorbent material over an inner portion thereof in order to reduce the effects of multiple reflections through a holder. Furthermore according to the present invention, the novel use of a separate control channel antenna obviates the need for cables connecting the device under test to the test equipment, thereby eliminating the spurious effects of cables on the measurements obtained using the apparatus.

According to a first aspect of the present invention, there is provided apparatus for measuring the radiation efficiency of a device, the apparatus comprising a chamber defining an internal cavity therein, a holder, located in the cavity, for supporting a device under test, a field stirrer, located in the cavity, for modifying electromagnetic radiation field patterns in the cavity, and a measurement device, located in the cavity, for measuring an electromagnetic radiation level in the cavity, characterised in that the field stirrer is located between the holder and the measurement device, such that a line of sight between the measurement device and the holder is obscured by the field stirrer.

According to a second aspect of the present invention, there is provided apparatus for measuring the radiation efficiency of a device, the apparatus comprising a chamber defining an internal cavity therein, a holder, located in the cavity, for supporting a device under test, a plurality field stirrers located in the cavity, for modifying electromagnetic radiation field patterns in the cavity, and a measurement device, located in the cavity, for measuring an electromagnetic radiation level in the cavity, characterised in that the field stirrers are coaxially mounted.

According to a third aspect of the present invention, there is provided apparatus for measuring the radiation efficiency of an antenna the apparatus comprising a chamber characterised in that the chamber includes an inner surface that carries radio absorbent material.

It should be emphasised that the term "comprises/comprising" when used in this specification is taken to specify the presence of stated features, integers, steps or components but does not preclude the presence or addition of one or more other features, integers, steps, components or groups thereof.

### BRIEF DESCRIPTION OF THE FIGURES

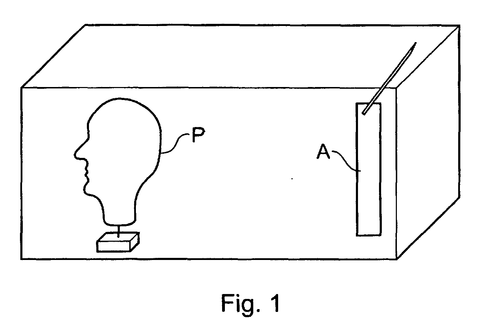

Figure 1 shows a testing chamber in accordance with the prior art;
Figure 2 is a diagrammatic representation of a first exemplary embodiment of one aspect of the present invention;
Figure 3 is a diagrammatic representation of a second exemplary embodiment of the present invention;
Figure 4 is a diagrammatic representation of a third exemplary embodiment of the present invention;
Figure 5 is a diagrammatic representation of a field chamber in accordance with an aspect of the present invention;
Figure 6 is a diagrammatic representation of a chamber without RAM; and
Figure 7 is a diagrammatic representation of an exemplary field stirrer in accordance with the present invention.

### DETAILED DESCRIPTION OF THE INVENTION

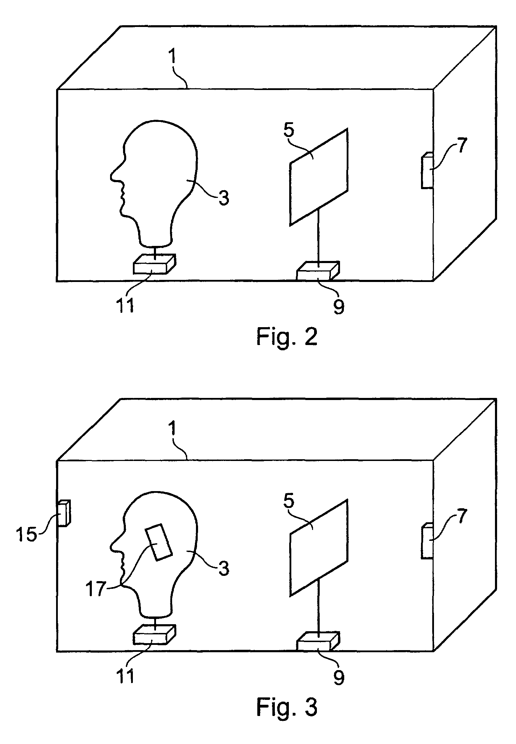

Figure 2 represents an exemplary embodiment of one aspect of the present invention. A scattered field chamber 1 defines a cavity therein which encloses a holder 3, a field stirrer 5 and a measurement device 7. The field stirrer 5 is arranged so that a direct line of sight between the holder 3 and measurement device 7 is obscured by the field stirrer 5.

The chamber 1 may be formed from a metal such as aluminium, which is strong and lightweight and which will accommodate the frequency modes required for a test. It will be appreciated, however, that the chamber may be constructed from any material suitable for accommodating the required modes.

It will be appreciated that although the holder 3 is shown in the shape of a human head, it may take any form. The holder enables a device under test to be mounted within the chamber in order to allow measurements of its radiation efficiency to be obtained.

The field stirrer 5 is mounted onto a motor 9 operable to rotate the field stirrer 5. The rotation of the field stirrer 5 facilitates the increase in the number of modes present within the chamber 1 by causing changes in the orientation of electromagnetically reflective elements which define the field stirrer.

In the embodiment of figure 2, a wireless device such as a mobile telephone (not shown) is mounted onto the holder 3. An additional motor 11 may facilitate rotation of the holder 3. If the device under test is mounted off-axis on the holder 3, the rotation will also cause a translation of the device under test.
This will allow particularly reliable and repeatable measurement results to be obtained as it will more accurately mimic the behaviour of a device in use in the field. Specifically, a device under normal use will not necessarily remain stationary and at a particular orientation, and rotation of the holder 3 reflects this.

Preferably, the measurement result as obtained by the device 7 may be averaged over all positions of the moving and rotated objects. If, for example, the measurement device 7 has a sampling rate of 5 measurements per second, then over a 5 minute period, 1500 measurements would be obtained. These measurements could be averaged in order to determine the average measured signal level. Fewer, or more, measurements could be taken. The exact number of measurements to be taken will depend on the particular nature of the apparatus being used, and the level of convergence required for the average signal.

Figure 3 represents a further exemplary embodiment of the present invention. As with the apparatus of figure 2, a chamber 1 encloses a holder 3, a field stirrer 5 and a measurement device 7. The field stirrer 5 is arranged so that a direct line of sight between the holder 3 and measurement device 7 is obscured by the field stirrer 5.

In addition, a control channel antenna 15 is incorporated within the apparatus. The control channel antenna 15 is operable to provide a radio communications channel signal to maintain a call in, for example, a mobile phone under test 17 located within the chamber 1 and mounted on the holder 3. The use of the antenna 15 obviates the need for the introduction of cables within the chamber 1. This is desirable as the effects of the cables on the electromagnetic waves within the chamber are difficult to determine and compensate for.

It is possible that in some circumstances it will be desirable to rotate the holder 3 whilst keeping the stirrer 5 stationary. The use of the control channel antenna 15 enables this as it obviates the need to connect cables to a device under test 17 which may become tangled during the rotation in addition to adding unwanted interference effects at the measurement device 7.

It will be appreciated from the exemplary figures 2 and 3 that the device under test 17, the field stirrer 5, and the measurement device 7 are arranged such that the field stirrer 5 is directly between the device under test 17 and the measurement device 7. This obviates the need for additional shielding within the chamber 1 as in the prior art, as the field stirrer 5 blocks the direct line of sight between the device under test 17 and the measurement device 7. As described, this ensures a true multi-path environment with Rayleigh fading characteristics as direct RF waves are not able to impinge upon the measurement device 7, but are instead received as reflections from the chamber walls and the surfaces of the field stirrer 5, whilst advantageously minimising the space required inside the chamber 1.

Although reference has been made above to the use of the apparatus for testing the radiation efficiency of a mobile phone, it should be noted that the apparatus as described is not intended to be limited to such a use. Indeed, the apparatus of the present invention may advantageously be applied to any technology in which it is desirable to measure the radiation efficiency of an antenna, and particularly, for example, it may equally be used for such measurements on pagers, personal digital assistants, Bluetooth enabled devices, and generally any devices in which data is to be transferred over an air interface either for reception or transmission purposes in the device.

In addition, the scattered field chamber 1 as described herein may also be operated in an 'inverse' fashion to that described, in which the device under test 17 is located generally in the same area as the measurement device 7 and vice versa. In this situation, the measurement device may be rotated by motor 11 with the stirrer(s) continuing their function of providing a substantially uniform scattered field from the device under test.

Similarly to the example shown in figure 2, the holder 3 of figure 3 may also be rotated using the motor 11 causing an additional translational motion to the device under test 17 when mounted to the holder 3 in an off-axis position as shown in figure 3.

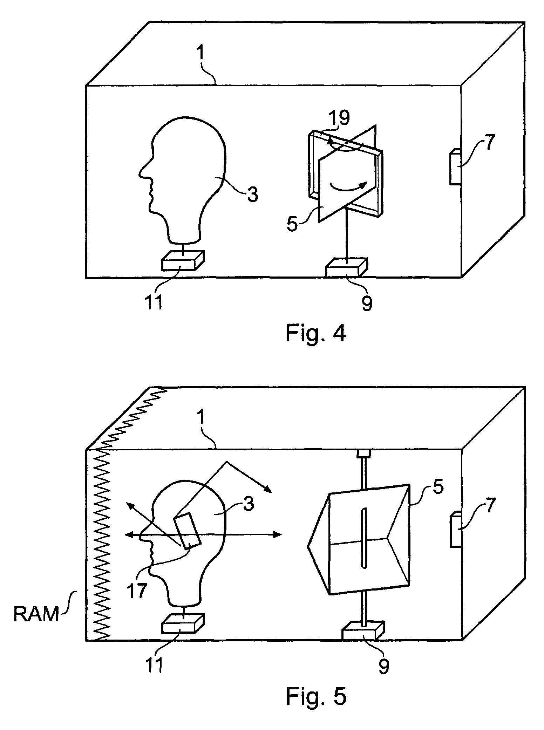

Figure 4 shows a further exemplary embodiment of the present invention. Again, the scattered field chamber 1 encloses a holder 3, a field stirrer 5 and a measurement device 7. The field stirrer 5 is mounted onto a motor 9 operable to rotate the field stirrer 5. Again, the holder 3 may also be rotated by means of the motor 11.

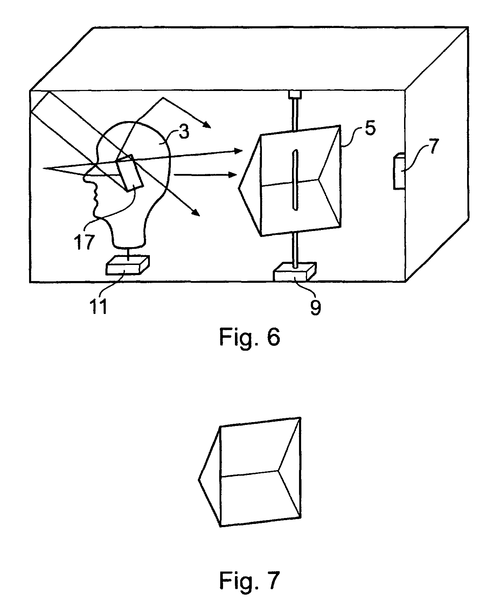

Figure 4 also shows an additional field stirrer 19. This stirrer is co-axially mounted onto the motor 9 with the first stirrer 5, and will advantageously rotate in an opposite direction to the first stirrer 5 such that the two stirrers 5, 19 form a contra-rotating set. Again, stirrer 5 may be of a shape as depicted in figure 6, whilst stirrer 19 may take any shape provided that it is able to be rotated in the opposite direction to the stirrer 5.

The stirrer(s) need not necessarily be mounted in the chamber 1 as depicted in figure 4. They may, for example, be mounted on a side wall of the chamber 1. The only requisite is that the stirrer 5 blocks the line of sight between the device under test 17 and the measurement device 7. The examples shown in the figures wherein the stirrer(s) are mounted on the floor of the chamber are not intended to be limiting, and are presented merely in order to better explain the inventive concepts embodied by the present invention.

In the example shown in figure 4, stirrer 19 has a rectangular form surrounding the field stirrer 5. Arrows indicating possible directions of rotation of the stirrers 5, 19 are included in figure 4. These are not intended to be limiting however. The stirrers 5, 19 may rotate in this manner or in the opposite manner to that shown, or may rotate in the same direction but with different speeds. In addition, the shape of the second field stirrer 19 is not intended to be limited to that shown, and may take any form provided that it is operable to rotate independently of the first field stirrer 5.

It will be appreciated that the inclusion of a second co-axially mounted stirrer 19 facilitates an increase in the amount of field stirring, as there are now more rotating surfaces from which electromagnetic radiation may reflect off. This provides a greater number of reflections in the chamber 1 thereby increasing the distribution of modes within the chamber 1. This will therefore help to simulate a multi-path environment more effectively, but without the need for an increase in the size of the chamber 1. This arrangement therefore allows for a particularly efficient use of space.

It is preferable that the rate of rotation of the stirrer(s) and that of the holder 3 (if rotated) are not synchronised. By rotating them independently, the range of different modes excited in the chamber 1 will be increased in comparison with the case where the stirrer(s) and the holder 3 are rotated at the same rate. Specifically, it is preferable that the rotation of the stirrer(s) and holder 3 is out of phase. The independent rates of rotation will improve the uniformity of the scattered field within the chamber 1, thereby improving the results obtained at the measurement device 7.

Preferably, the stirring rate in the chamber 1 is greater than the sampling rate of the measurement device 7. This ensures that there are not multiple samples of the same field distribution, thereby improving the measurement accuracy for a given number of samples. The stirring rate is governed primarily, but not exclusively, by the rotation rates of the field stirrers 5,19 and the holder 3.

Figure 5 shows a further exemplary embodiment of the present invention. The chamber 1 this time includes radio absorbent material (RAM) over an interior surface of the chamber 1 as shown. As is conventional, the RAM may be carbon loaded foam, arranged either as pyramidal cones, blankets or as horizontal and vertical wedges over the interior surface of the chamber 1. The RAM reduces reflections within the chamber 1 which would not normally occur in use. For example, the reflection of radiated energy which would normally be radiated away from the measurement device would cause additional signals in the absence of reflection reducing material. Such RAM allows more accurate simulation of a free space environment. The absorption is an irreversible conversion of the energy of the electromagnetic waves into another form of energy as a result of the wave interaction with matter.

By locating the RAM at the position shown in figure 5 allows the holder 3 to be used in a small chamber (for example, with dimensions as small as 0.5x0.5x1.0m for measurements at 900 MHz). Under circumstances in which the RAM were not present, the presence of the holder 3 in the chamber 1 would have an exaggerated effect due to multiple reflections passing through the holder 3. These multiple reflections are not representative of a typical mobile radio environment, and are therefore absorbed by the RAM of figure 5 thereby facilitating the use of such small scattered field chambers.

Figure 6 shows the situation were the RAM not present in the embodiment of figure 5. It is clear to see that multiple reflections from the rear wall of the chamber of figure 6 would be present. These multiple reflections may pass through the holder 3 and become attenuated due to the losses incurred thereby. Such reflections are not representative of a typical mobile RF environment.

Figure 7 shows a representation of the possible form of the field stirrer 5. It is essentially triangular in shape. Specifically, in the embodiment of figure 7, the field stirrer 5 is defined by a first planar surface, a second planar surface arranged to intersect the first planar surface, and two further planar surfaces arranged on either side of the intersecting surfaces in such a way as to define a hollow region therein. It will be appreciated, however, that any shape may be used providing that it is arranged such that, in operation (i.e. whilst being rotated), it blocks the direct line of sight between the device under test mounted on the holder 3 and the measurement device 7. The field stirrer 5 has this arrangement as it is desirable to block the direct line of sight between a device under test and the measurement device 7 so that RF waves from the device under test do not directly impinge onto the measurement device 7. In this way, only reflected waves are received at the measurement device 7, thereby simulating a multi-path environment more accurately.

It will be appreciated by those skilled in the art, that although the present invention has been described with reference to specific examples of some apparatus and materials, these are not intended to be limiting, and have only been included for the sake of clarity, and to better describe the inventive concept embodied by the present invention.

For example, the chamber 1 of the present invention may be fabricated from any suitable material which is operable to contain the required modes within the chamber. For example, plated steel, copper or brass would be suitable materials for the chamber 1.

Further, the RAM may be formed from any suitable material and arrangement thereof as is common in the art. For example, carbon coated mineral wools or carbon loaded foams may be used, as well as other common forms of RAM not expressly mentioned herein.

## Claims

1. Apparatus for measuring the radiation efficiency of a device, the apparatus comprising
a chamber (1) defining an internal cavity therein;
a holder (3), located in the cavity, for supporting a device under test;
a field stirrer (5), located in the cavity, for modifying electromagnetic radiation field patterns in the cavity; and
a measurement device (7), located in the cavity, for measuring an electromagnetic radiation level in the cavity,
**characterised in that** the field stirrer (5) is located between the holder (3) and the measurement device (7), such that a line of sight between the measurement device (7) and the holder (3) is obscured by the field stirrer (5).

2. Apparatus as claimed in claim 1, wherein the chamber (1) is defined by a plurality of surfaces formed from electromagnetically reflective material.

3. Apparatus as claimed in claim 2, wherein the electromagnetically reflective material is Aluminium (Al).

4. Apparatus as claimed in any of claims 1 to 3, wherein the chamber 1 has a volume in the range of 0.25m³ to 1m³.

5. Apparatus as claimed in 1, wherein the field stirrer 5 is formed from electromagnetically reflective material.

6. Apparatus as claimed in claim 5, wherein the electromagnetically reflective material is Aluminium (Al).

7. Apparatus as claimed in any one of the preceding claims, wherein the field stirrer 5 is a hollow pyramidal shaped field stirrer.

8. Apparatus as claimed in any one of the preceding claims, wherein the field stirrer (5) is rotatably mounted within the chamber (1).

9. Apparatus as claimed in any one of the preceding claims, wherein the device under test holder (3) is rotatably mounted within the chamber (1).

10. Apparatus for measuring the radiation efficiency of a device, the apparatus comprising
a chamber (1) defining an internal cavity therein;
a holder (3), located in the cavity, for supporting a device under test;
a plurality field stirrers (5), (19), located in the cavity, for modifying electromagnetic radiation field patterns in the cavity; and
a measurement device (7), located in the cavity, for measuring an electromagnetic radiation level in the cavity,
**characterised in that** the field stirrers (5), (19) are coaxially mounted.

11. Apparatus as claimed in claim 10, wherein the chamber (1) is defined by a plurality of surfaces formed from electromagnetically reflective material.

12. Apparatus as claimed in claim 11, wherein the electromagnetically reflective material is Aluminium (Al).

13. Apparatus as claimed in any of claims 10 to 12, wherein the chamber (1) has a volume in the range of 0.25m³ to 1m³.

14. Apparatus as claimed in 10, wherein at least one of the field stirrers (5), (19) is formed from electromagnetically reflective material.

15. Apparatus as claimed in claim 14, wherein the electromagnetically reflective material is Aluminium (Al).

16. Apparatus as claimed in any of claims 10, 14 or 15, wherein one of the field stirrers (5), (19) is a hollow pyramidal shaped field stirrer.

17. Apparatus as claimed in any one of claims 10, 14, 15 or 16, wherein at least one of the field stirrers (5), (19) is rotatably mounted within the chamber (1).

18. Apparatus for measuring the radiation efficiency of an antenna the apparatus comprising a chamber (1)
**characterised in that** the chamber (1) includes an inner surface that carries radio absorbent material.

19. Apparatus as claimed in claim 18, wherein the chamber (1) is formed from electromagnetically reflective material.

20. Apparatus as claimed in claim 19, wherein the electromagnetically reflective material is Aluminium (Al).

21. Apparatus as claimed in any of claims 18 to 20, wherein the chamber 1 has a volume in the range of 0.25m³ to 1m³.

22. Apparatus as claimed in claim 18, wherein the radio absorbent material is in the form of pyramidal cones.

23. Apparatus as claimed in any of claims 18 to 22, wherein the radio absorbent material is arranged as a blanket over the inner surface of the chamber (1).

24. Apparatus as claimed in any of claims 18 to 22, wherein the radio absorbent material is arranged as horizontal wedges over the inner surface of the chamber (1).

25. Apparatus as claimed in any of claims 18 to 22, wherein the radio absorbent material is arranged as vertical wedges over the inner surface of the chamber (1).

26. A method of testing the radiation efficiency of an antenna using an apparatus as claimed in any one of the preceding claims.
